(19) Europäisches Patentamt
European Patent Office
Office européen des brevets

(11) **EP 0 646 544 B1**

(12) **EUROPÄISCHE PATENTSCHRIFT**

(45) Veröffentlichungstag und Bekanntmachung des Hinweises auf die Patenterteilung:
**13.08.1997 Patentblatt 1997/33**

(51) Int. Cl.$^6$: **C01B 31/02**, B01J 19/08

(21) Anmeldenummer: 94115504.6

(22) Anmeldetag: 30.09.1994

(54) **Verfahren und Vorrichtung zur Herstellung von Fullerenen**

Process and apparatus for the preparation of fullerenes

Procédé et appareil pour la préparation de fullerènes

(84) Benannte Vertragsstaaten:
**AT CH DE FR GB LI**

(30) Priorität: **02.10.1993 DE 4333683**

(43) Veröffentlichungstag der Anmeldung:
**05.04.1995 Patentblatt 1995/14**

(73) Patentinhaber: **Keesmann, Till**
**D-69115 Heidelberg (DE)**

(72) Erfinder:
• **Keesmann, Till**
**D-69115 Heidelberg (DE)**
• **Grosse-Wilde, Hubert, Dr.**
**D-91077 Neunkirchen a.Br. (DE)**

(74) Vertreter: **Clemens, Gerhard, Dr.-Ing. et al**
**Patentanwaltskanzlei,**
**Müller, Clemens & Hach,**
**Lerchenstrasse 56**
**74074 Heilbronn (DE)**

(56) Entgegenhaltungen:
**EP-A- 0 527 035**       **EP-A- 0 536 500**
**WO-A-93/01128**       **DE-U- 9 314 960**

• **'GMELINS HANDBUCH DER ANORGANISCHEN CHEMIE KOHLENSTOFF Teil C - Lieferung 1' 1970 , VERLAG CHEMIE GMBH , WEINHEIM, DE * Seite 127 - Seite 129 ***
• **'GMELINS HANDBUCH DER ANORGANISCHEN CHEMIE KOHLENSTOFF Teil C2' 1972 , VERLAG CHEMIE GMBH , WEINHEIM, DE * Seite 6 : 1.4 ***
• **SPEKTRUM DER WISSENSCHAFT, Dezember 1991, HEIDELBERG, DE Seiten 88 - 98 R. F. CURL ET AL.**

**Beschreibung**

TECHNISCHES GEBIET

Die Erfindung betrifft ein Verfahren zur Herstellung von Fullerenen. Fullerene sind Hohl- oder Käfigmoleküle, deren Hüllen aus einem geschlossenen Netzwerk aus fünfeckigen und sechseckigen Ringen aus Kohlenstoffatomen bestehen. Die Anzahl der Kohlenstoffatome X ergibt sich aus der Gleichung $X = 20 + 2*m$. Darin bedeuten m die Anzahl der Sechserringe (Hexagone). Es hat sich gezeigt, daß die Fullerene mit der Kohlenstoffatomzahl $X = 60$ und größer besonders stabil sind. Die Erfindung betrifft weiterhin eine Vorrichtung zur Herstellung von Fullerenen mit einer Reaktionsbehältereinrichtung und Elektroden.

STAND DER TECHNIK

Zum erstenmal gelang es Krätschmer und anderen, Fullerene in wägbaren Mengen durch Verdampfen eines elektrisch geheizten Graphitstabes in einer Heliumatmosphäre herzustellen, wie in Nature, Vol 347 (1990), S. 354 ff beschrieben ist. Die Fullerene können aus dem Ruß, der sich in dem Versuchsgefäß niederschlägt, durch organische Lösungsmittel wie Toluol oder Benzol ausgewaschen werden.

Nach der ersten Veröffentlichung von Krätschmer sind eine Reihe von Verbesserungen und alternativen Verfahren bekannt geworden, nach denen Fullerene hergestellt werden können. So wird in dem Buch "Buckminsterfullerenes", VCH Verlagsgesellschaft mbH, Weinheim (1993), S. 302 ff ein Reaktorgefäß beschrieben, das eine einfachere Herstellung der Fullerene nach dem Krätschmer-Verfahren erlaubt. Ein anderes Verfahren, das in der Zeitschrift Spektrum der Wissenschaft, Dezember 1991, S. 88 ff beschrieben ist, beruht darauf, daß Kohlenstoff von den Graphitelektroden eines Lichtbogens abdampft und sich an den Wänden des Lichtbogengefäßes als Ruß niederschlägt, der als Bestandteil Fullerene enthält. In der WO 93 01 128 A1 ist ein Verfahren beschrieben, bei dem ein Kohlestab durch Heizen elektrisch leitfähig gemacht und dann in einer sauerstofffreien Atmosphäre durch elektrische Heizung zumindest teilweise verdampft wird. In der europäischen Patentanmeldung EP 0 536 500 A1 wird demgegenüber ein Verfahren beschrieben, bei dem die Fullerenerzeugung in einer sauerstoffhaltigen Atmosphäre geschieht. In der europäischen Patentanmeldung EP 527 035 wird ein Verfahren zur Herstellung von Fullerenen beschrieben, bei dem kohlehaltige Partikel kleinen Durchmessers in einen Lichtbogen gegeben werden und die Partikel durch die Energie des Lichtbogens verdampfen und sich bei der Abkühlung des Dampfes außerhalb des heißen Kernes des Lichtbogens Fullerene bilden. In der WO 92 20 622 A1 wird ein Verfahren zur Herstellung von Fullerenen durch Verbrennen kohlenstoffhaltiger Verbindungen unter Einhaltung spezieller Bedingungen beschrieben. Bei allen diesen Verfahren wird zunächst Kohlenstoff auf eine hohe Temperatur von mehr als 2000 °C gebracht; bei der Diffusion des Kohlenstoffs aus dem heißen Bereich in kältere Zonen des Reaktionsgefäß findet dann unter bisher noch nicht ganz verstandenen Bedingungen der Zusammenschluß der Kohlenstoffatome zu den Fullerenen statt. Dieser Diffusionsvorgang läßt sich nur unzulänglich durch Druck und Art des Puffergases, Temperatur oder Stromstärke des Lichtbogens oder der Leistung der elektrischen Heizung des Graphitstabes steuern. Demzufolge sind die Ausbeuten bei der Herstellung der Fullerene auch nur gering und es entstehen hauptsächlich die Fullerene mit den Kohlenstoffzahlen 60 und 70 ($C_{60}$ und $C_{70}$). Fullerene mit höheren Kohlenstoffzahlen sind nur in verschwindend geringen Mengen nachgewiesen worden.

DARSTELLUNG DER ERFINDUNG

Der Erfindung liegt das technische Problem bzw. die Aufgabe zugrunde, ein gegenüber dem genannten Stand der Technik verbessertes Verfahren zur Verfügung zu stellen, das einen einfachen und wirtschaftlichen apparativen Aufbau ermöglicht, mit dem eine Hohe Ausbeute an Käfigmolekülen erzielt werden kann, mit dem die Bedingungen für die Bildung der Käfigmoleküle gezielt und empfindlich einstellbar sind. Darüber hinaus ist es Aufgabe der Erfindung, eine Vorrichtung zur Durchführung des o. g. Verfahrens anzugeben. Das erfindungsgemäße Verfahren ist durch die Merkmale des Anspruchs 1 gegeben. Die erfindungsgemäße Vorrichtung zur Herstellung ist durch die Merkmale des Anspruchs 9 gegeben. Vorteilhafte Ausgestaltungen und Weiterbildungen sind Gegenstand der Unteransprüche.

Das erfindungsgemäße Verfahren zeichnet sich durch folgende Verfahrensschritte aus: Einbringen eines Gasgemisches, das zwischen 10 % und 100 % Kohlenmonoxid (CO), insbesondere 30 % bis 60 %, enthält, und Zünden einer Glimmentladung innerhalb der Reaktionsbehältereinrichtung.

Die Bildung der Fullerene findet in einer Glimmentladung statt, die das Reaktionsgefäß bevorzugt weitgehend gleichmäßig ausfüllt. Insbesondere wird von der Tatsache Gebrauch gemacht, daß in einer Glimmentladung die Gastemperatur sehr viel niedriger sein kann als die Elektronentemperatur, die durch die mittlere kinetische Energie der Elektronen gegeben ist. Beispielsweise liegt die Elektronentemperatur in Glimmentladungen, die für die Anregung von $CO_2$-Gaslasern benutzt werden, zwischen 1,0 eV und 1,5 eV (entsprechend etwa 11.000 K bzw. 16.500 K), während die Gastemperatur unter 200 °C liegt. Für die Synthese der Fullerene wird nun in der Glimmentladung die Gastemperatur so eingestellt, daß bei dieser Temperatur die Fullerene stabil sind und nicht zerfallen. Die erforderliche Energie für den Zusammenschluß der Kohlenstoffatome zu den geordneten Strukturen der Fullerene wird den aus wenigen Atomen bestehenden Ketten- oder ringförmigen Kohlenstoffclustern, die die Vorstufe der Fullerene bilden, durch Stöße mit den Elektronen zugeführt. Daneben kann auch eine Energieübertragung auf die Kohlenstoffcluster durch inelastische Stöße mit angeregten Gaspartikeln stattfinden.

Für die erfindungsgemäße Herstellung der Fullerene wird von der bekannten Tatsache Gebrauch gemacht, daß aus Glimmentladungen mit einem hohen Kohlenmonoxidanteil (CO) Kohlenstoff in Form von Ruß ausfällt. (Gmelin, Handbuch der Anorganischen Chemie, Kohlenstoff Teil C2, Seite 6, Verlag Chemie, Weinheim (1972)). Ursache hierfür ist die dissoziative Ionisation der CO-Moleküle durch Elektronenstöße. Nach Gmelin, Handbuch der Anorganischen Chemie Teil C, Lieferung 1, S. 127 ff, Verlag Chemie, Weinheim (1970), sind die wesentlichen Prozesse in reinem CO-Gas:

$$CO + e \rightarrow C^+ + O^- + e$$

$$CO + e \rightarrow C^+ + O + 2e$$

$$CO + e \rightarrow C + O^+ + 2e$$

Bei Gasgemischen mit Edelgasen oder anderen Molekülgasen nimmt die Anzahl der stattfindenden Reaktionen stark zu. Insbesondere entstehen bei längerer Verweilzeit eines Gasvolumens in der Glimmentladung Sekundärprodukte, die das Gleichgewicht verschieben. So bildet sich aus dem CO neben Kohlenstoff und Sauerstoff auch $CO_2$.

Über den bei Gmelin genannten Parameterbereich hinaus kann die Glimmentladung auch bei höheren Drücken bis zu einigen Hundert mbar betrieben werden, wenn die Entladung über eine kapazitiv eingekoppelte Hochfrequenz angeregt wird. Derartige Anordnungen werden unter anderem zur Anregung von Gaslasern eingesetzt und sind in der EP 0 275 023 beschrieben. Auch Gleichstromentladungen in Rohren mit mehreren Zentimetern Durchmesser lassen sich bis zu Drücken von 50 mbar und mehr als Glimmentladung betreiben, wenn dafür gesorgt wird, daß die Gastemperatur einen Wert von etwa 350 °C nicht übersteigt. Bei höheren Temperaturen besteht die Gefahr, daß ein Lichtbogen entsteht, der zur Zerstörung des Entladungsgefäßes führen kann. Zur Kontrolle der Gastemperatur muß entweder die Wand des Entladungsgefäßes gekühlt werden oder das Gas muß so schnell ausgetauscht werden, daß die Verlustleistung der Glimmentladung hinreichend schnell mit dem Gasstrom abgeführt wird.

Eine bevorzugte Ausgestaltung zeichnet sich dadurch aus, daß die elektrische Energiezuführung getaktet erfolgt, wobei das Tastverhältnis zwischen 10 % und 90 % liegen kann. Damit läßt sich die Energiedichte steuern, indem von 10 % bis 90 % einer Taktperiode elektrische Energie zugeführt wird oder nicht.

Für die Herstellung der Fullerene in einer Glimmentladung werden insbesondere die folgenden Größen geeignet gewählt und aufeinander abgestimmt:

- Gaszusammensetzung,
- Druck,
- elektrische Leistungsdichte,
- Gastemperatur,
- Verweildauer des Gases im Glimmentladungsraum, d. h. die Strömungsgeschwindigkeit des Gases.

Vorteilhaft ist die Verwendung von Helium neben Kohlenmonoxid, weil das erste angeregte Niveau bei Helium bei ca. 20 eV metastabil ist, d. h., daß das Helium bei inelastischen Stößen mit Kohlenstoffclustern relativ viel Energie an diese abgeben kann. Gute Ergebnisse lassen sich mit einem Gemisch von 40 % bis 60 % CO und 60 % bis 40 % Helium erzielen.

Der Druck in der Glimmentladung sollte möglichst hoch sein, damit die Kohlenstoffdichte, die bei der dissoziativen Ionisation des CO entsteht, möglichst groß ist. Andererseits neigt die Glimmentladung mit steigendem Druck zur Bogenbildung. Mit einer Hochfrequenzanregung lassen sich Glimmentladungen bis zu 150 mbar problemlos betreiben, solange die Gastemperatur nicht über etwa 300 °C anwächst.

Leistungsdichte, Druck und Gaszusammensetzung lassen sich nicht völlig unabhängig voneinander einstellen; vielmehr stellt sich in der stationären Gasentladung ein Zustand ein, bei dem die Erzeugungsrate und Vernichtungsrate der Ladungsträger gleich ist. Dies ist im allgemeinen bei gegebenem Druck und gegebener Gaszusammensetzung nur in einem eingeschränkten Bereich der Leistungsdichte der Fall. Für die obengenannten Bedingungen ist dies zwischen 50 und 130 Watt/cm$^3$ der Fall.

Die Gastemperatur ergibt sich für den stationären Fall aus der eingekoppelten elektrischen Leistung und den Kühlbedingungen der Gasentladung. Die Verlustleistung kann über die Wände des Entladungsgefäßes abgeführt werden, die beispielsweise durch Wasser gekühlt werden, oder dadurch, daß Gas kontinuierlich ausgetauscht wird und die Verlustleistung als fühlbare Wärme des Gasgemisches abgeführt wird. Auch eine Kombination beider Verfahren ist leicht realisierbar.

Neben der Abfuhr der Wärme bietet der kontinuierliche Gasaustausch den weiteren Vorteil, daß die Gaszusammensetzung sich während der begrenzten Verweilzeit des Gases im Glimmentladungsraum nur unwesentlich ändert. Die Verweilzeit T erreichnet sich aus der Strömungsgeschwindigkeit v und der Länge der Entladungskammer L zu T = L/v . Ein weiterer Vorteil liegt darin, daß die Fullerene, die sich in der Glimmentladung bilden, mit der Strömung aus dem Reaktionsraum getragen werden und beispielsweise durch eine Waschflasche mit einem organischen Lösungsmittel wie Benzol oder Toluol ausgewaschen werden können.

Da der Gasdruck aus Gründen der Stabilität der Glimmentladung nicht so hoch gewählt werden kann, wie es für die Bildung der Fullerene wünschenswert wäre, kann die Dichte der Kohlenstoffatome und Kohlenstoffcluster niedriger Atomzahl dadurch im Glimmentladungsraum erhöht werden, daß der Dampf eines heißen Graphitkörpers in das Glimmentladungsgefäß geleitet wird. Dies kann entweder durch Diffusion in den Glimmentladungsraum oder durch Beladen des einströmenden Gases mit dem Dampf geschehen.

Die erfindungsgemäße Vorrichtung zur Herstellung von Käfigmolekülen weist eine Reaktionsbehältereinrichtung, innerhalb derer eine Glimmentladung, insbesondere Gleichstromglimmentladung durchführbar und zumindest eine Elektrode auf, und zeichnet sich dadurch aus, daß die Elektrode zumindest bereichsweise aus einem Graphitkörper besteht, der durch einen zusätzlichen Strom auf Weißglut erhitzbar ist.

Weitere Ausführungsformen und Vorteile der Erfindung ergeben sich durch die in den Ansprüchen ferner aufgeführten Merkmale sowie durch die nachstehend angegebenen Ausführungsbeispiele. Die Merkmale der Ansprüche können in beliebiger Weise miteinander kombiniert werden, insoweit sie sich nicht offensichtlich gegenseitig ausschließen.

KURZE BESCHREIBUNG DER ZEICHNUNG

Die Erfindung sowie vorteilhafte Ausführungsformen und Weiterbildungen derselben werden im folgenden anhand der in der Zeichnung dargestellten Beispiele näher beschrieben und erläutert. Die der Beschreibung und der Zeichnung zu entnehmenden Merkmale können einzeln für sich oder zu mehreren in beliebiger Kombination erfindungsgemäß angewandt werden. Es zeigen:

Fig. 1    schematische Darstellung einer Reaktionsbehältereinrichtung für eine Gleichstromglimmentladung zur Herstellung von Fullerenen,

Fig. 2    schematische Darstellung einer Reaktionsbehältereinrichtung für eine hochfrequenzangeregte Glimmentladung zur Herstellung von Fullerenen,

Fig. 3    Querschnitt eines Entladungsgefäßes für eine Hochfrequenzglimmentladung gemäß Fig. 2,

Fig. 4    schematische Detaildarstellung einer Gleichstromreaktionsbehältereinrichtung mit einem heizbaren Graphitkörper und

Fig. 5    schematische Detaildarstellung einer Hochfrequenzreaktionsbehältereinrichtung mit einem heizbaren Graphitkörper.

WEGE ZUM AUSFÜHREN DER ERFINDUNG

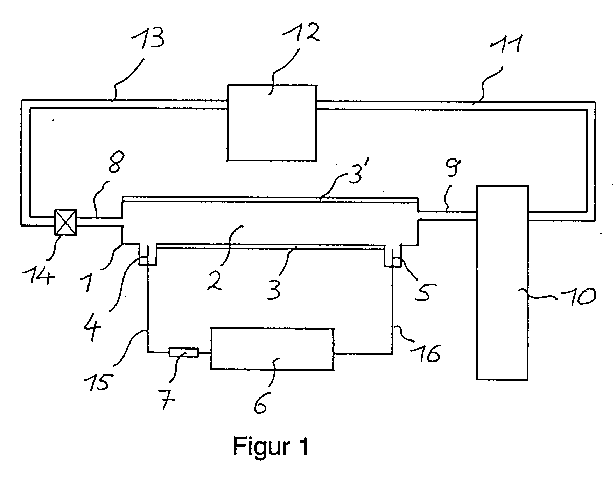

In Fig. 1 bezeichnet 1 ein Entladungsgefäß (Reaktionsbehältereinrichtung) für die Gleichstromglimmentladung, die einen Entladungsraum 2 umschließt, in dem das durch eine Gasleitung 8 zugeführte Gasgemisch angeregt wird. Das Entladungsgefäß 1 ist doppelwandig ausgeführt, so daß durch einen zylindrischen Hohlraum 3,3' Kühlwasser geleitet werden kann. Die hierfür notwendigen Anschlüsse sind hier nicht gezeichnet. Die elektrische Anregung erfolgt über ein Hochspannungsgerät 6, das über die Zuleitungen 15 und 16 mit Elektroden 4 und 5 verbunden ist. Die Elektroden 4 und 5 ragen in den Entladungsraum 2 hinein. Zur Begrenzung des Stromes durch die Entladung dient ein Vorwiderstand 7. Das Gasgemisch wird mittels einer Pumpe 12 über Gasleitungen 8, 9, 11 und 13 durch den Entladungsraum 2 und durch eine mit einem organischen Lösungsmittel gefüllte Waschflasche 10 in einen geschlossenen Kreislauf geführt.

Dabei kann der Durchfluß mit einem Ventil 14 eingestellt werden. Vorteilhaft wird in geringem Umfang Frischgas kontinuierlich zugeführt und ein Teil des umlaufenden Gases ausgetauscht (in Fig. 1 nicht dargestellt).

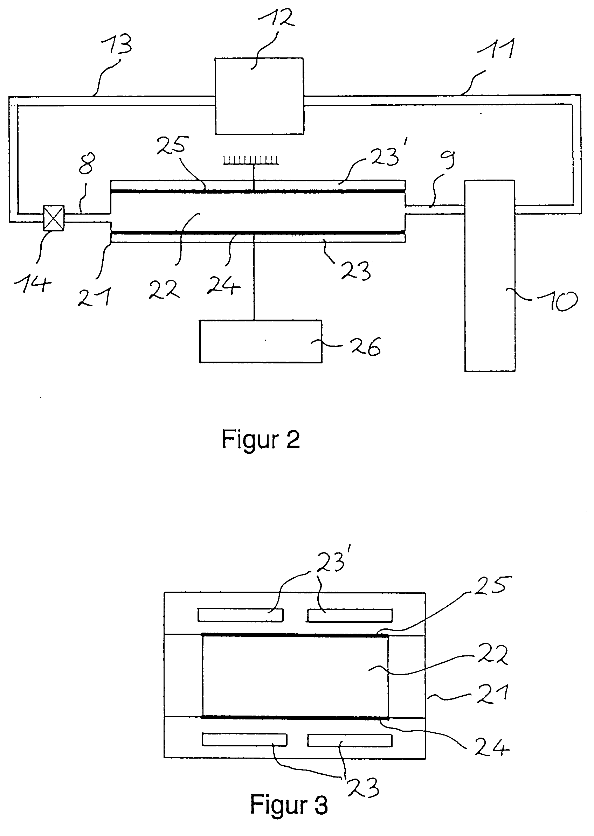

In Fig. 2 ist eine erfindungsgemäße Anordnung gezeichnet, bei der im Gegensatz zu Fig. 1 die Gasentladung über einen Hochfrequenzgenerator betrieben wird. Der Gaskreislauf ist identisch mit dem aus Fi. 1. Gleiche Bauteile tragen dasselbe Bezugszeichen wie in Fig. 1 und werden nich nochmals erläutert. Ein Entladungsgefäß 21 umschließt einen Gasraum 22, in welchem vermittels von Elektroden 24 und 25, welche sich über die gesamte Länge des Entladungsgefäßes 21 erstrecken, eine Hochfrequenzentladung erzeugt wird. Mit 26 ist ein Hochfrequenzgenerator bezeichnet, der auch die erforderlichen elektrischen Anpassungsglieder enthält. Die beschriebene Reaktionsbehältereinrichtung kann in gleicher Weise mit niederfrequentem Wechselstrom, vorzugsweise zwischen 50 Hz und 400 Hz, betrieben werden. Hierzu ist lediglich das Hochspannungsgerät 6 geeignet auszuwählen.

In Fig. 3 ist ein Querschnitt des Hochfrequenzentladungsgefäßes gemäß Fig. 2 dargestellt. Das Entladungsgefäß 21 selbst besteht aus einem elektrisch nichtleitenden Keramikmaterial, beispielsweise $Al_2O_3$. In der oberen und unteren Wand sind Kühlbohrungen 23 und 23' eingelassen, durch die Kühlwasser gepumpt werden kann. Die Elektroden 24 und 25 bestehen aus einem metallischen Werkstoff wie Aluminium, Kupfer oder Edelstahl. Es ist auch möglich, die katalytische Wirkung metallischer Oberflächen auszunutzen, um die Zusammensetzung des Gasgemisches, die sich durch die Entladung ändert, vorteilhaft zu beeihflussen.

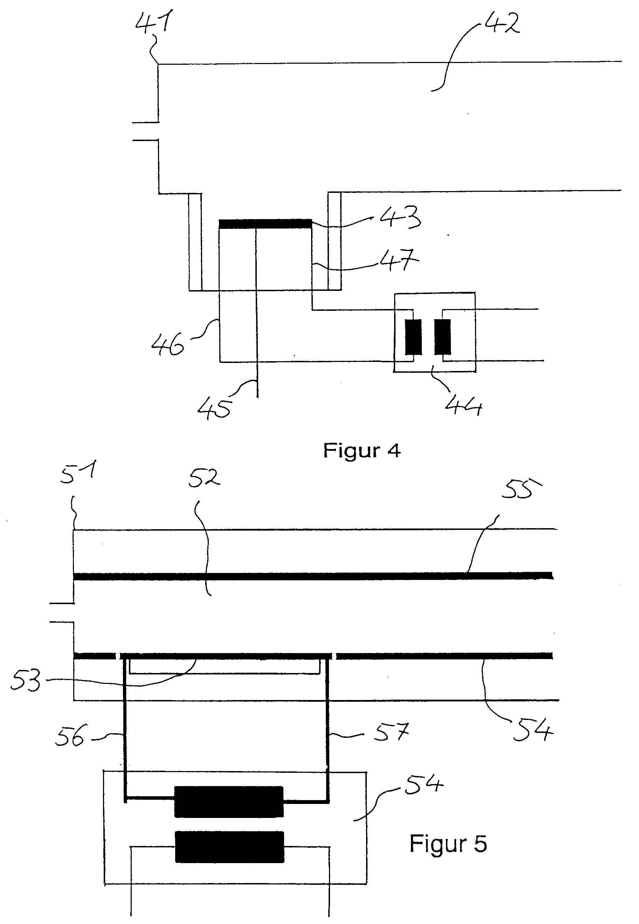

In Fig. 4 ist schematisch mit 41 ein Gleichstromentladungsgefäß mit einem Entladungsraum 42 bezeichnet. Eine Elektrode 43 ist als Graphitkörper ausgebildet, der durch einen Wechselstrom auf Weißglut erhitzt werden kann. Mit 45 ist die Zuleitung für den Strom durch die Gasentladung bezeichnet. Der Wechselstrom wird mittels eines Trenntransformators 44 erzeugt und über Zuleitungen 46, 47 der Elektrode 43 zugeführt.

In Fig. 5 ist schematisch mit 51 ein Hochfrequenzentladungsgefäß mit einem Entladungsraum 52 dargestellt. Ein kleiner Teil einer Hochfrequenzelektrode 54 ist durch einen länglichen Graphitkörper 53 ersetzt, der durch einen Wechselstrom auf Weißglut erhitzt werden kann. Der Wechselstrom geeigneter Stromstärke und Spannung wird über einen Trenntransformator 55 erzeugt und dem Graphitkörper über entsprechende Zuleitungen 56 und 57 zugeführt.

Am Beispiel einer mit Hochfrequenz angeregten Glimmentladung wird die Erfindung näher erläutert. Ein 60 cm langes Entladungsgefäß aus $Al_2O_3$, das entsprechend Fig. 2 mit Wasser gekühlt wird und das innenliegende Elektroden aus eloxiertem Aluminium hat, wird auf einer Seite an eine Gasflasche mit vorgemischtem Gas aus 50 % Helium und 50 % CO angeschlossen. An der gegenüberliegenden Seite führt eine Gasleitung zu einer Waschflasche mit Toluol. Auf der Austrittsseite der Waschflasche ist eine Pumpe angeschlossen. Im Unterschied zur Fig. 2 wird das Gas nicht im Kreislauf geführt. Das Entladungsgefäß ist an einen Hochfrequenzgenerator der Frequenz 56 MHz angeschlossen, die maximale Leistung beträgt 1000 W. Der Zufluß des Gases und die Pumpleistung werden so eingestellt, daß die Verweilzeit des Gases im Entladungsraum etwa 5 Sekunden beträgt. Während einer Betriebsdauer von 10 Minuten sammelt sich in der Waschflasche Roh-Fulleren an, das hauptsächlich die Atomzahlen 60 und 70 enthält.

Durch Änderung der Betriebsparameter wie Gaszusammensetzung, Druck, Leistungsdichte und Durchflußgeschwindigkeit kann die Ausbeute optimiert und die Zusammensetzung des Rohfullerens variiert werden. Besonders vorteilhaft ist die Beladung des Gasstromes mit Graphitdampf vor dem Entladungsgefäß oder an der Einströmseite im Entladungsgefäß.

Ein weiterer Vorteil der Erfindung liegt darin, daß die Bildung der Fullerene im Volumen der Entladung erfolgt. Dadurch ist es ohne weiteres möglich, in großvolumigen Glimmentladungen Fullerene in größerem Maßstab herzustellen. Ähnliche Glimmentladungen werden beispielsweise in $CO_2$-Lasern hoher Leistung für die Materialbearbeitung eingesetzt. Das Verfahren ist also skalierbar bis zu Anlagen zur kommerziellen Herstellung von Fullerenen.

**Patentansprüche**

1. Verfahren zur Herstellung von Fullerenen genannten Käfigmolekülen aus Kohlenstoffatomen mit geschlossenen Netzwerken, insbesondere aus fünf- und/oder sechseckigen Ringen, in einer Reaktionsbehältereinrichtung
**gekennzeichnet durch**
folgende Verfahrensschritte

   - Einbringen eines Gasgemisches, das zwischen 10 % und 100 % Kohlenmonoxid (CO), insbesondere 30 % bis 60 %, enthält, und
   - Herstellen einer Glimmentladung innerhalb der Reaktionsbehältereinrichtung.

2. Verfahren nach Anspruch 1,
**dadurch gekennzeichnet,** daß
die Glimmentladung die Reaktionsbehältereinrichtung im wesentlichen gleichmäßig ausfüllt.

3. Verfahren nach Anspruch 1 oder 2,
**dadurch gekennzeichnet,** daß
ein Gasgemisch eingebracht wird, das neben CO auch Helium (He) und/oder Argon (Ar) und/oder Kohlendioxid ($CO_2$) enthält.

4. Verfahren nach einem oder mehreren der vorstehenden Ansprüche,
**dadurch gekennzeichnet,** daß
die Glimmentladung durch Gleichstrom angeregt wird.

5. Verfahren nach einem oder mehreren der vorstehenden Ansprüche,
**dadurch gekennzeichnet,** daß
die Glimmentladung durch niederfrequenten Wechselstrom, vorzugsweise zwischen 50 Hz und 400 Hz, angeregt wird.

6. Verfahren nach einem oder mehreren der vorstehenden Ansprüche,
**dadurch gekennzeichnet,** daß
die Glimmentladung durch Hochfrequenz angeregt wird, wobei die Frequenz zwischen 100 kHz und 10 GHz liegen kann.

7. Verfahren nach einem oder mehreren der vorstehenden Ansprüche,
**dadurch gekennzeichnet,** daß
die elektrische Energiezuführung getaktet erfolgt, wobei das Tastverhältnis zwischen 10 % und 90 % liegen kann.

8. Verfahren nach einem oder mehreren der vorstehenden Ansprüche,
**dadurch gekennzeichnet,** daß
zusätzlicher Kohlenstoffdampf in den Raum der Glimmentladung von einem heißen Graphitkörper diffundiert.

9. Verfahren nach einem oder mehreren der vorstehenden Ansprüche,
**dadurch gekennzeichnet,** daß
das Gasgemisch den Glimmentladungsraum durchströmt und nach Verlassen der Glimmentladungszone die Fullerene aus dem Gasgemisch durch Auswaschen mit einem organischen Lösungsmittel gewonnen werden.

10. Verfahren nach Anspruch 9,
**dadurch gekennzeichnet,** daß
das Gasgemisch im Kreislauf geführt wird und wahlweise ein frisches Gasgemisch zugesetzt wird.

**11.** Vorrichtung zur Herstellung von Käfigmolekülen, insbesondere nach einem oder mehreren der Verfahrensansprüche 1 bis 10, mit

- einer Reaktionsbehältereinrichtung, innerhalb derer eine Glimmentladung, insbesondere Gleichstromglimmentladung, durchführbar ist, und
- zumindest einer Elektrode,

**dadurch gekennzeichnet,** daß die Elektrode zumindest bereichsweise aus einem Graphitkörper besteht, der durch einen zusätzlichen Strom auf Weißglut erhitzbar ist.

**12.** Vorrichtung nach Anspruch 11, **gekennzeichnet durch** eine Hochfrequenzeinrichtung, die insbesondere in einem Frequenzbereich von 100 kHz und 10 GHz arbeitet und die die Glimmentladung durch kapazitive Kopplung anregt.

**13.** Vorrichtung nach Anspruch 11 oder 12, **dadurch gekennzeichnet,** daß eine Zuström- und/oder Abströmöffnung für ein Gasgemisch vorhanden ist.

**14.** Vorrichtung nach Anspruch 13, **dadurch gekennzeichnet,** daß die Elektrode mit dem Graphitkörper in der Nähe der Zuströmöffnung angeordnet ist.

**15.** Vorrichtung nach einem oder mehreren der vorstehenden Ansprüche 11 bis 14, **dadurch gekennzeichnet,** daß die Wandung der Reaktionsbehältereinrichtung zumindest bereichsweise kühlbar ausgebildet ist.

**Claims**

**1.** Method and apparatus for production of cage molecules of carbon atoms with closed networks, especially of pentagonal and hexagonal rings, called fullerenes, in a reaction chamber device, **characterized by**

- feeding of a gas mixture, which contains between 10% and 95% carbon monoxide (CO), especially 30% to 60%, and
- exciting a glow discharge within the reaction chamber device.

**2.** Method according to claim 1, **characterized in that**

- the glow discharge occupies in essence homogenuosly the reaction chamber device.

**3.** Method according to claim 1 or 2, **characterized in that**

- a gas mixture is feeded in, which contains in addition to CO also helium (He) and/or argon (Ar) and/or carbon dioxide ($CO_2$).

**4.** Method according to any one or several of the preceding claims, **characterized in that**

- the glow discharge is excited by direct current (dc).

**5.** Method according to any one or several of the preceding claims, **characterized in that**

- the glow discharge is excited by alternating current of low frequency, especially between 50 Hz and 400 Hz.

**6.** Method according to any one or several of the preceding claims, **characterized in that**

- the glow discharge is excited by high frequency, whereby the frequency can be between 100 kHz and 10 GHz.

**7.** Method according to any one or several of the preceding claims, **characterized in that**

- the energy transmission is supplied with clock pulses, whereby the pulse-duty factor can be between 10% and 90%.

**8.** Method according to any one or several of the preceding claims, **characterized in that**

- in addition carbon vapor of a hot graphite body can diffuse into the volume of the glow discharge.

**9.** Method according to any one or several of the preceding claims, **characterized in that**

- the gas mixture is flowing through the glow discharge chamber and after leaving the glow discharge volume the fullerenes are gained by washing out with an organic solvent.

**10.** Method according to claim 9, **characterized in that**

- the gas mixture is circulated and optionally added fresh gas mixture.

11. Apparatus for production of cage molecules, especially according to any one or several of the method claims 1 to 10, with
a reaction chamber device, in which a glow discharge, especially a direct current glow discharge, is exciteable, and
at least one electrode,
**characterized in that**

- the electrode consists at least in parts of a graphite body, which is heatable up to white heat by an additional current.

12. Apparatus according to claim 11,
**characterized by**

- a high frequency device, which works especially in a frequency range from 100 kHz to 10 GHz and which excites the glow discharge by capacitiv coupling.

13. Apparatus according to claim 11 or 12,
**characterized in that**

- an inflow and/or outflow opening for a gas mixture is apparent.

14. Apparatus according to claim 13
**characterized in that**

- the electrode with the graphite body is arranged near to the inflow opening.

15. Apparatus according to any one or several of the preceding claims 11 to 14,
**characterized in that**

- the walls of the reaction chamber device can be cooled at least in parts.

**Revendications**

1. Procédé de préparation de fullérènes, appelés molécules en cage, à partir d'atomes de carbone à structure réticulée fermée, notamment à partir d'anneaux pentagonaux et/ou hexagonaux, dans un dispositif de récipient de réaction ou réacteur, procédé caractérisé par les étapes opératoires suivantes :

- introduction d'un mélange gazeux, qui contient entre 10% et 100% d'oxyde de carbone (CO), en particulier 30% à 60%, et
- réalisation d'une décharge électrique à faible lueur, ou effet couronne, dans le réacteur.

2. Procédé selon la revendication 1, caractérisé en ce que la décharge électrique à faible lueur emplit de façon essentiellement uniforme le réacteur.

3. Procédé selon la revendication 1 ou 2, caractérisé en ce qu'est introduit un mélange gazeux contenant, en plus de CO, également de l'hélium (He) et/ou de l'argon (Ar) et/ou du dioxyde de carbone ($CO_2$).

4. Procédé selon une ou plusieurs des revendications précédentes, caractérisé en ce que la décharge électrique à faible lueur est excitée par du courant continu.

5. Procédé selon une ou plusieurs des revendications précédentes, caractérisé en ce que la décharge électrique est excitée par du courant alternatif à basse fréquence, comprise avantageusement entre 50 Hz et 400 Hz.

6. Procédé selon une ou plusieurs des revendications précédentes, caractérisé en ce que la décharge électrique est excitée par de la haute fréquence, la fréquence pouvant se situer entre 100 kHz et 10 GHz.

7. Procédé selon une ou plusieurs des revendications précédentes, caractérisé en ce que l'alimentation en énergie électrique a lieu de façon cadencée, le taux des impulsions pouvant se situer entre 10% et 90%.

8. Procédé selon une ou plusieurs des revendications précédentes, caractérisé en ce que de la vapeur de carbone supplémentaire diffuse à partir d'un corps de graphite chaud dans l'espace où se produit la décharge électrique à faible lueur.

9. Procédé selon une ou plusieurs des revendications précédentes, caractérisé en ce que le mélange gazeux traverse l'espace de la décharge électrique et, après que ce mélange ait quitté la zone de la décharge électrique, les fullérènes sont récupérés du mélange gazeux par extraction par lavage à l'aide d'un solvant organique.

10. Procédé selon la revendication 9, caractérisé en ce que le mélange gazeux est acheminé en cycle fermé et est additionné, selon les nécessités, d'un mélange gazeux frais.

11. Dispositif pour la production de molécules en cage, notamment selon une ou plusieurs des revendications 1 à 10, le dispositif comportant :

- une installation de récipient de réaction ou de réacteur, dont l'intérieur peut être parcouru par une décharge électrique à faible lueur ou à effet couronne, en particulier une décharge de courant continu à faible lueur, et
- au moins une électrode,

caractérisé en ce que l'électrode consiste, au moins en certaines zones, en un corps de graphite pouvant être porté à incandescence par chauffage à l'aide d'un courant supplémentaire.

12. Dispositif selon la revendication 11, caractérisé par une installation à haute fréquence, qui travaille notamment dans un domaine des fréquences de 100 kHz et de 10 GHz et qui excite par couplage capacitif la décharge à faible lueur.

13. Dispositif selon la revendication 11 ou 12, caractérisé par la présence d'une ouverture pour l'acheminement et/ou la sortie d'un mélange gazeux.

14. Dispositif selon la revendication 13, caractérisé en ce que l'électrode comportant le corps en graphite est disposée au voisinage de l'ouverture d'acheminement du gaz ou d'alimentation en gaz.

15. Dispositif selon l'une ou plusieurs des revendications 11 à 14 précédentes, caractérisé en ce que la paroi du réacteur ou du dispositif de récipient de réaction est réalisée de façon à pouvoir être refroidie au moins par zone(s).

Figur 1

Figur 2

Figur 3

Figur 4

Figur 5